# EUROPÄISCHE PATENTSCHRIFT

(11) **EP 0 828 226 B1**
(45) Veröffentlichungstag und Bekanntmachung des Hinweises auf die Patenterteilung: **17.12.2003**
(21) Anmeldenummer: 97113734.4
(22) Anmeldetag: 08.08.1997
(51) Int. Cl.: G06K 13/077, H05K 5/02

(54) **Gehäuse für Personal-Computer-Karten (PC-Cards)**
Casing for PC cards
Boîtier pour cartes PC

(30) Priorität: 06.09.1996 DE 29615553 U
(43) Veröffentlichungstag der Anmeldung: 11.03.1998
(73) Patentinhaber: STOCKO Contact GmbH & Co. KG, 42327 Wuppertal (DE)
(72) Erfinder: Plötz, Stefan, 58769 Nachrodt-Wiblingwerde (DE); Gross, Walter, 53937 Schleiden-Olef (DE)
(74) Vertreter: Stenger, Watzke & Ring Patentanwälte

(56) Entgegenhaltungen:
- DE-A- 4 428 717
- US-A- 5 061 845
- US-A- 5 397 857
- US-A- 5 505 628
- "PERSONAL COMPUTER MEMORY CARD INTERNATIONAL ASSOCIATION FRAME/COVERDESIGN" IBM TECHNICAL DISCLOSURE BULLETIN,US,IBM CORP. NEW YORK, Bd. 38, Nr. 11, 1. November 1995 (1995-11-01), Seite 269 XP000547362 ISSN: 0018-8689

## Beschreibung

Die Erfindung betrifft ein Gehäuse für Personal-Computer-Karten (PC-Cards), insbesondere PCMCIA-Cards, deren Leiterplatte in einen Kunststoffrahmen eingesetzt und in diesem befestigt ist.

Aus der DE-OS 44 28 717 ist ein Gehäuse für eine Personal-Computer-Karte bekannt, bei der die Leiterplatte zwischen zwei schalenförmigen Teilen angeordnet ist, welche durch ineinandergreifende Rinnen in Form einer Schnappverbindung miteinander verbunden werden und nach dem Zusammenbau der PC-Karte die Leiterplatte ohne weitere Befestigungsmittel, Klebstoffe, Schweißen oder andere zeitaufwendige oder komplizierte Verbindungsprozeduren oder -systeme hält. Das Gehäuse ist aus vorzugsweise rostfreiem Stahl aufgebaut, um die erforderliche Festigkeit und Steifigkeit als auch eine elektrisch leitende abschirmende Umhüllung für die elektronischen Bauteile bereitzustellen. Nachteilig ist, daß allein mit einem derartigen Stahlgehäuse eine sichere Fixierung der Leiterplatte im Gehäuse nicht möglich ist. In der Praxis wird daher die Leiterplatte zunächst in einen Kunststoffrahmen eingesetzt, welcher wiederum von dem beschriebenen Metallaußengehäuse umhüllt wird, um einen effektiven Einschluß der Leiterplatte im Gehäuse mit der erforderlichen Festigkeit und Steifigkeit bei sicherer Fixierung über die gesamte Lebensdauer zu gewährleisten.

Der dabei verwendete Festsitz der Leiterplatte im Kunststoffrahmen wird in der Regel durch Verkleben erreicht. Zu diesem Zweck weist der Kunststoffrahmen eine im Querschnitt L-förmige Aufnahme für die Leiterplatte auf, die im Rahmen des Fertigungsvorgangs mit einem geeigneten Klebstoff versehen wird. Sodann wird die Leiterplatte von oben in die L-förmige Aufnahme eingesetzt, wird das Aushärten des Klebstoffs abgewartet und wird sodann die mit Kunststoffrahmen versehene Leiterplatte in das oben beschriebene Metallaußengehäuse eingebracht. Nachteilig ist dabei, daß die Dosierung des Klebemittels schwierig ist, die Neigung zu einer Verschmutzung durch Bindung von Staub gegeben ist und bei einer unpräzisen Anwendung des Klebemittels Störungen der elektronischen Funktion auftreten können. Darüber hinaus ist dies Herstellungsverfahren technisch aufwendig und zeitraubend. Aufgrund des steigenden Bedarfs an tragbaren Computern, wie Notebooks, werden auch immer höhere Anforderungen an die Herstellung elektronischer Zusatzspeicher in Form von PC-Karten gestellt, die in einen Schacht einschiebbar und mittels einer Steckverbindung mit dem Computer kontaktierbar sind und je nach Ausgestaltung der elektronischen Konfigurationen unterschiedlichste Erweiterungen für den tragbaren Computer bereitstellen.

Der Erfindung liegt in Anbetracht dieses Standes der Technik die **Aufgabe** zugrunde, die beschriebenen Nachteile zu beheben und eine einfache Möglichkeit bereitzustellen, die Leiterplatte nachträglich in den Kunststoffrahmen einzubringen und positionsgenau zu fixieren, ohne daß dabei ein Verkleben oder ein Vernieten oder Verschrauben durchgeführt werden muß. Dabei soll auch erreicht werden, daß die Leiterplatte ggf. aus dem Kunststoffrahmen wieder entfernbar und austauschbar ist, damit beim Auftreten von Schäden an der Leiterplatte z.B. durch kalte Lötstellen, nicht weiter der Austausch der gesamten Karte und deren Entsorgung erforderlich ist.

Die Aufgabe ist **erfindungsgemäß** dadurch gelöst, daß der Kunststoffrahmen an einer Seite, vorzugsweise am Kontaktleistenende der Personal-Computer-Karte, offen und derart im wesentlichen U-förmig mit flexiblen Seitenarmen ausgebildet ist, und daß der Kunststoffrahmen eine nach innen offene Einschubführung für die Leiterplatte aufweist, die diese nach ihrem Einschieben im Kunststoffrahmen positioniert und nach oben sowie nach unten fixiert. Vorzugsweise hat die Führung für die Leiterplatte die Form einer kontinuierlich oder unterbrochen umlaufenden Führungsnut, wobei die unterbrochene Führungsnut vorzugsweise gegeneinander versetzte untere Auflagen und obere Gegenhalter aufweist. Damit ist die Möglichkeit geschaffen, die Leiterplatte nachträglich in den Kunststoff-Spritzling einzuschieben, ohne daß geklebt werden muß, da untere Auflagen und obere Gegenhalter entweder in Form einer kontinuierlichen oder unterbrochenen Führungsnut, auch in Form von versetzten Vorsprüngen vorgesehen sind, die eine sichere Positionierung und Halterung der Leiterplatte gewährleisten.

Gemäß einer vorteilhaften Ausgestaltung der Erfindung kann mindestens eine weitere, nach innen vorspringende Auflage für die Leiterplatte an jeder Seite des Kunststoffrahmens vorgesehen sein, um sowohl das Einschieben der Leiterplatte durch eine bessere Führung zu erleichtern als auch im Fertigzustand den Sitz zu verbessern. Vorteilhafterweise setzen hierzu die Auflagen die unteren Führungsflächen der Führung, insbesondere Führungsnut, nach innen niveaugleich fort.

In dem gleichen Sinne können zusätzlich obere, nach innen vorspringende Haltevorsprünge an einer oder mehreren Seiten des Kunststoffrahmens vorgesehen sein, wobei vorzugsweise die Haltevorsprünge die obere Führungsfläche der Führung, insbesondere Führungsnut nach innen niveaugleich fortsetzen.

Um bei der großen Anzahl notwendiger Ausführungsformen von Leiterplatten zu gewährleisten, daß diese immer mit dem passenden Kunststoffrahmen versehen werden, wird gemäß einer zweckmäßigen Ausgestaltung der Erfindung vorgeschlagen, den Kunststoffrahmen und die Leiterplatte mit einer zusammenwirkenden Vorsprung/Ausnehmungs-Anordnung im Bereich der Führungsnut am Steckende als Kodierung zu versehen. Ergänzend kann eine gleichartige Kodierung auch an den Seitenarmen des Kunststoffrahmens und der Leiterplatte in Form einer zusammenwirkenden Vorsprung/Ausnehmungs-Anordnung vorgesehen sein.

Der eigentliche Kontaktierungsbereich einer Personal-Computer-Karte wird durch eine Kontaktleiste am Einschubende der Leiterplatte bereitgestellt, wobei für die häufigen Vorgänge des Einsteckens und Herausziehens eine sichere Fixierung der Kontaktleiste im Kunststoffrahmen gewährleistet sein muß. Zu diesem Zweck wird in vorteilhafter Weise vorgeschlagen, die Seitenarme des Kunststoffrahmens zur Erfassung der Kontaktleiste zu verlängern und beidseitig mit einer Gabelhalterung zu versehen, die mit einem eingreifenden Haltevorsprung der Kontaktleiste an jeder Seite zur Fixierung der Kontaktleiste korrespondiert. Dabei kann der eine, innere Arm der Gabelhalterung die Stirnkante der Leiterplatte berühren, um eine Sicherung gegen axiale Verschiebbarkeit der Leiterplatte im Kunststoffrahmen bereitzustellen.

In an sich bekannter Weise kann das derart aufgebaute Gehäuse der Erfindung in ein Metallaußengehäuse eingesetzt sein.

Weitere Einzelheiten, Merkmale und Vorteile des Gegenstandes der Erfindung ergeben sich aus der nachfolgenden Beschreibung der zugehörigen Zeichnung, in der eine bevorzugte Ausführungsform eines erfindungsgemäßen Gehäuses für eine PCMCIA-Karte dargestellt ist. In der Zeichnung zeigt:
- Fig. 1: eine Draufsicht eines Kunststoffrahmens eines PC-Card-Gehäuses;
- Fig. 2: die Leiterplatte und den Kunststoffrahmen in komplett montierter Form in einer Ansicht von unten;
- Fig. 3: eine Leiterplatte einer PC-Card mit PCMCIA-Kontaktleiste in Draufsicht;
- Fig. 4: einen Querschnitt gemäß Linie A-A der Fig. 1

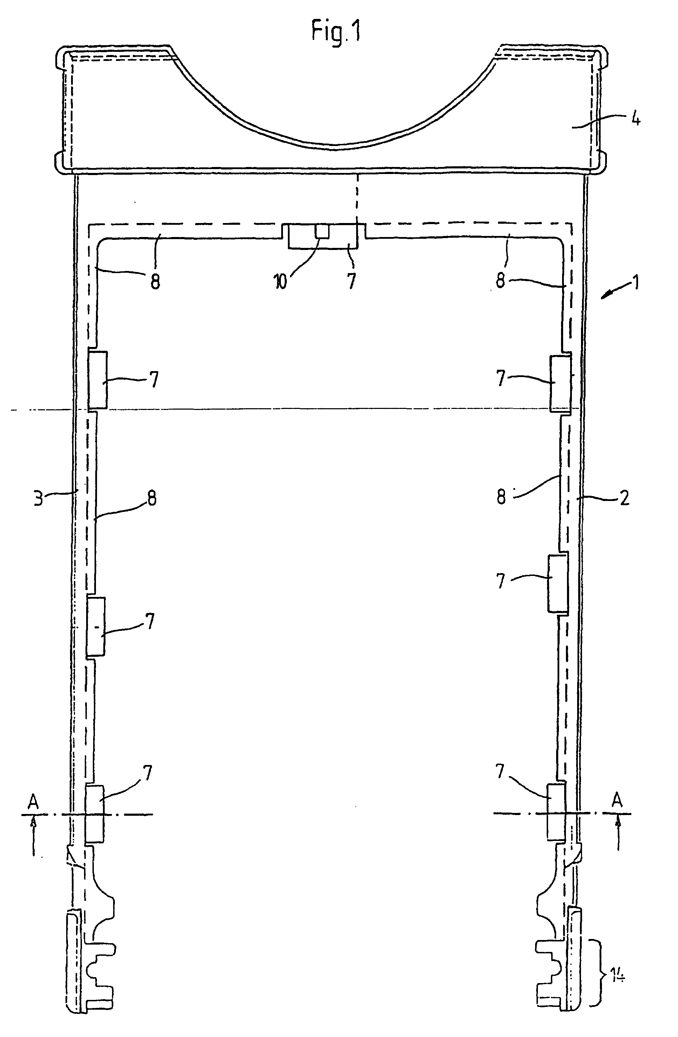

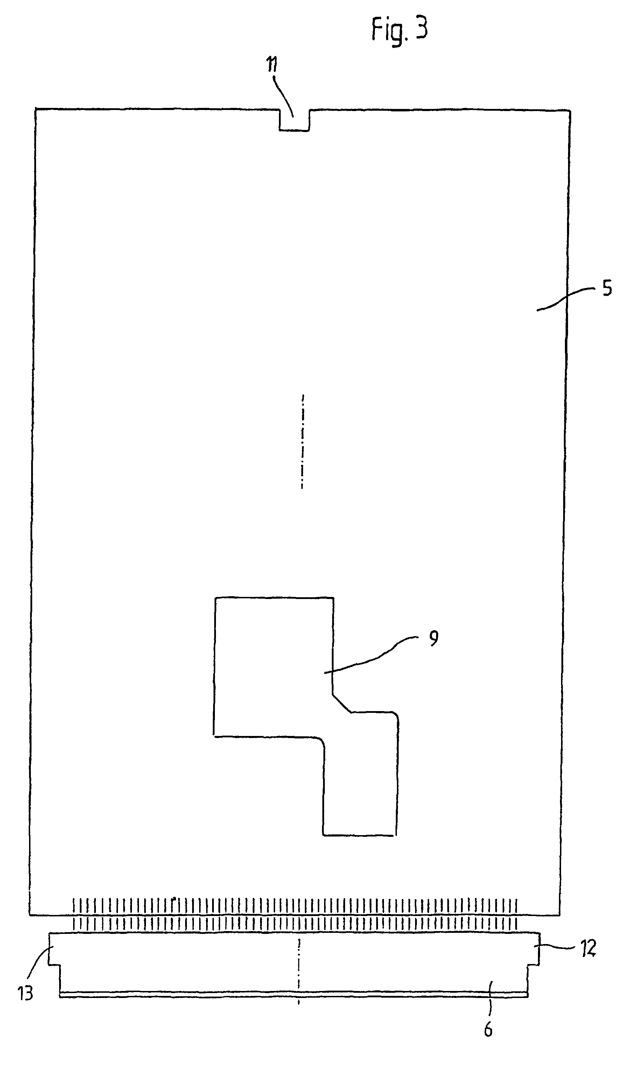

Der in Fig. 1 der Zeichnung in Draufsicht dargestellte Kunststoffrahmen 1 weist im wesentlich eine U-Form auf, wobei zueinander mit Abstand parallel verlaufende Seitenarme 2, 3 durch ein querverlaufendes verbindendes Steckende 4 oder Handhabungsende einstückig als Kunststoff-Spritzteil miteinander verbunden sind. Die Seitenarme 2, 3 sind dabei flexibel ausgebildet und zur Vereinfachung der Montage nach allen Richtungen, insbesondere auch nach außen ausbiegbar. Der Kunststoffrahmen 1 ist vorgesehen, eine Leiterplatte 5 aufzunehmen und ohne eine Klebeverbindung positionsgenau und gesichert gegen Verschiebungen sowie Herausfallen oder Verkanten nach oben und unten zu halten. Eine Leiterplatte 5 ist Fig. 3 der Zeichnung entnehmbar. Sie weist in herkömmlicher Weise eine gedruckte Schaltung oder Platine auf, auf der eine Vielzahl elektronischer Komponenten 9, beispielsweise durch Lötanschlüsse, montiert sind, was als bekannt vorauszusetzen ist und an dieser Stelle nicht näher zu beschreiben ist. Das in Einsteckrichtung gesehen vordere Ende der Leiterplatte weist dabei eine Kontaktleiste 6 auf, die mit 68 PCMCIA-Steckkontakten zum Anschluß an einen Personal-Computer versehen ist.

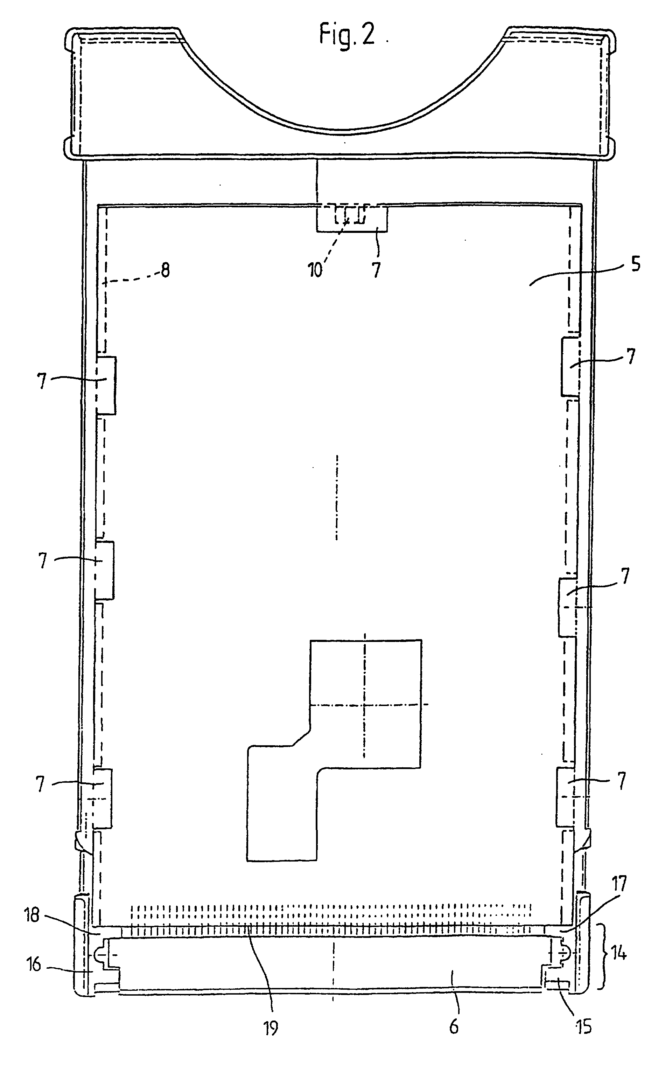

Die Leiterplatte 5 ist in Fig. 2 der Zeichnung in einem in den Kunststoffrahmen 1 eingesetzten, insbesondere eingeschobenen, Zustand dargestellt, wobei der Kunststoffrahmen 1 dem Schutz der Leiterplatte 5 dient und eine feste, sichere Umhüllung der Leiterplatte 5 darstellt, die darüber hinaus hervorragend geeignet ist, in ein - zeichnerisch nicht dargestelltes - Metallaußengehäuse eingesetzt zu werden.

Um die Leiterplatte 5 ohne Verkleben positionsgenau in dem Kunststoffrahmen 1 halten zu können, weist dieser eine nach innen offene Führung für die Leiterplatte 5 auf, die diese nach ihrer Einführung im Kunststoffrahmen 1 positioniert und nach oben sowie nach unten fixiert. Die Führung kann die Form einer kontinuierlich umlaufenden Führungsnut haben. Bei einer solchen, nicht dargestellten Ausführungsform wird die Leiterplatte 5 von der offenen Seite des U-förmigen Kunststoffrahmens 1 her in die Führungsnut eingeschoben, bis sie am Steckende 4 innerhalb der dort querverlaufenden Führungsnut zur Anlage kommt. Nach einer anderen Ausführungsform ist die nach innen offene Führung in Form einer unterbrochenen umlaufenden Führungsnut, die ebenfalls nicht dargestellt ist, ausgebildet. Dabei finden sich untere Auflagen für die einzuschiebende Leiterplatte 5 und obere Gegenhalter koaxial übereinander.

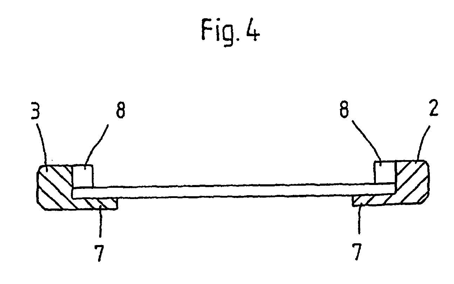

In der bevorzugten, zeichnerisch dargestellten Ausführungsform ist eine unterbrochen umlaufende Führung vorgesehen, bei der gegeneinander versetzte untere Auflagen 7 und obere Gegenhalter 8 dazu dienen, die eingeschobene Leiterplatte 5 zu fixieren. Dies ist der Fig. 2 der Zeichnung gut zu entnehmen, die in einer Ansicht von unten zeigt, wie die Leiterplatte 5 auf den unteren Auflagen 7 aufliegt, während Fig. 1 der Zeichnung die oberen Gegenhalter 8 entnehmbar sind, die versetzt zu den unteren Auflagen 7 angeordnet sind, wobei die Auflagen 7 und Gegenhalter 8 in einem Abstand versetzt übereinander angeordnet sind, der geringfügig größer als die Stärke der Leiterplatte 5 ist. Aus der Zeichnung ist dabei auch erkennbar, daß die unteren Auflagen 7 relativ weit nach innen vorspringen, um sowohl das Einschieben der Leiterplatte 5 durch eine bessere Führung zu erleichtern als auch im Fertigzustand den Sitz der Leiterplatte, d.h. die Abstützung von unten, zu verbessern. Dazu setzen die Auflagen 7 die unteren Führungsflächen der Führung nach innen niveaugleich fort, wie Fig. 4 der Zeichnung in der Schnittansicht A-A entnehmbar ist. In dem gleichen Sinne können zusätzlich obere, nach innen vorspringende Haltevorsprünge an einer oder mehreren Seiten des Kunststoffrahmens 1 vorgesehen sein, jedoch zeigt die zeichnerisch dargestellte Ausführungsform derartige obere Haltevorsprünge nicht.

Der Kunststoffrahmen 1 ist im Bereich der Führung etwa außermittig am Steckende 4 mit einem Vorsprung 10 in Form einer einstückigen Kunststoffanspritzung direkt oberhalb der dortigen Auflage 7 versehen, der mit einer entsprechenden Ausnehmung 11 der Leiterplatte zusammenwirkt, um als Vorsprung/Ausnehmungs-Anordnung eine Kodierung darzustellen, die beim Zusammenbau gewährleistet, daß jeweils der passende Kunststoffrahmen mit der zugehörigen Leiterplatte montiert wird. Ergänzend können gleichartige Kodierungen auch an den Seitenarmen 2, 3 in Form von Vorsprüngen und entsprechenden Ausnehmungen der Leiterplatte vorgesehen werden.

Das in Einsteckrichtung gesehen vordere Ende der Leiterplatte 5 weist die PCMCIA-Kontaktleiste 6 auf, die den eigentlichen Kontaktierungsbereich darstellt, der in den zugehörigen Schacht des Computers, insbesondere Notebooks, eingeschoben wird und über eine Steckverbindung elektrisch angeschlossen wird. Die Kontaktleiste 6 weist an beiden Seiten je einen durch eine Abstufung hergestellten Vorsprung 12, 13 auf, der zur Positionierung und Fixierung im Kunststoffrahmen 1 gebraucht wird. Hierzu sind die Seitenarme 2, 3 des Kunststoffrahmens 1 in Einsteckrichtung zur vollständigen Erfassung der Kontaktleiste 6 um den Bereich 14 verlängert und beidseitig mit einer nach innen gerichteten Gabelhalterung 15, 16 versehen, die einstückig aus Kunststoff mit den Seitenarmen 2, 3 hergestellt ist. Die Gabelhalterungen 15, 16 erfassen die zugehörigen Haltevorsprünge 12, 13 der Leiterplatte 5 im zusammengebauten Zustand (vgl. Fig. 2 der Zeichnung), wobei zusätzlich der hintere Arm 17, 18 der Gabelhalterung 15 bzw. 16 die benachbarte Stirnfläche 19 der Leiterplatte 5 berührt, um eine Sicherung gegen eine axiale Verschiebung der Leiterplatte 5 im Kunststoffrahmen 1 bereitzustellen.

### Bezugszeichenliste

- 1: Kunststoffrahmen
- 2: Seitenarme
- 3: Seitenarme
- 4: Steckende
- 5: Leiterplatte
- 6: Kontaktleiste
- 7: untere Auflagen
- 8: obere Gegenhalter
- 9: elektronische Komponenten
- 10: Vorsprung
- 11: Ausnehmung
- 12: Vorsprung
- 13: Vorsprung
- 14: Bereich
- 15: Gabelhalterung
- 16: Gabelhalterung
- 17: hinterer Arm
- 18: hinterer Arm
- 19: Stirnfläche

## Patentansprüche

1. Gehäuse für Personal-Computer-Karten (PC-Cards), insbesondere PCMCIA-Cards, deren Leiterplatte in einen Kunststoffrahmen eingesetzt und in diesem befestigt ist,
**dadurch gekennzeichnet,**
**daß** der Kunststoffrahmen (1) an einer Seite, vorzugsweise am Kontaktleistenende (6) der PC-Card (5), offen und derart im wesentlichen U-förmig mit flexiblen Seitenarmen (2, 3) ausgebildet ist, und
**daß** der Kunststoffrahmen (1) eine nach innen offene Führung für die Leiterplatte (5) aufweist, die diese nach ihrer Einführung im Kunststoffrahmen (1) positioniert und nach oben sowie nach unten fixiert.

2. Gehäuse nach Anspruch 1, **dadurch gekennzeichnet, daß** die Führung für die Leiterplatte (5) die Form einer kontinuierlich oder unterbrochen umlaufenden Führungsnut hat, wobei die unterbrochene Führungsnut vorzugsweise gegeneinander versetzte untere Auflagen (7) und obere Gegenhalter (8) aufweist.

3. Gehäuse nach Anspruch 1 oder 2, **gekennzeichnet durch** mindestens eine nach innen vorspringende Auflage (7) für die Leiterplatte (5) an jeder Seite des Kunststoffrahmens (1 ).

4. Gehäuse nach Anspruch 3, **dadurch gekennzeichnet, daß** die Auflagen (7) die unteren Führungsflächen der Führung, insbesondere Führungsnut, nach innen niveaugleich fortsetzen.

5. Gehäuse nach einem der Ansprüche 1 bis 4, **gekennzeichnet durch** obere, nach innen vorspringende Haltevorsprünge an einer oder mehreren Seiten des Kunststoffrahmens.

6. Gehäuse nach Anspruch 5, **dadurch gekennzeichnet, daß** die Haltevorsprünge die obere Führungsfläche der Führung, insbesondere Führungsnut, nach innen niveaugleich fortsetzen.

7. Gehäuse nach einem der Ansprüche 1 bis 6, **dadurch gekennzeichnet, daß** die Leiterplatte (5) und der Kunststoffrahmen (1) mit einer zusammenwirkenden Vorsprung/Ausnehmungs-Anordnung (10, 11) im Bereich der Führungsnut am Steckende (4) als Kodierung versehen sind.

8. Gehäuse nach einem der Ansprüche 1 bis 7, **dadurch gekennzeichnet, daß** die Leiterplatte (5) und die Seitenarme (2, 3) des Kunststoffrahmens mit Vorsprung/Ausnehmungs-Anordnungen als Kodierungen versehen sind.

9. Gehäuse nach einem der Ansprüche 1 bis 8, **dadurch gekennzeichnet, daß** die Seitenarme (2, 3) des Kunststoffrahmens (1) zur Erfassung der Kontaktleiste (6) verlängert sind und beidseitig mit einer Gabelhalterung (15, 16) versehen sind, die mit einem eingreifenden Haltevorsprung (12, 13) der Kontaktleiste (6) an jedem Ende zur Fixierung der Kontaktleiste (6) korrespondiert.

10. Gehäuse nach einem der Ansprüche 1 bis 9, **dadurch gekennzeichnet daß** es in ein Metallgehäuse zur Aufnahme des Kunststoffrahmens (1) mit eingesetzter Leiterplatte eingesetzt wird.

## Claims

1. Casing for personal computer cards (PC cards), in particular for PCMCIA cards with a circuit board inserted into a plastic frame and fixed in position in it,
**characterised in that** the plastic frame (1) is formed with one open side substantially of U-shape with flexible side arms (2, 3), preferably at the end of the contact strip (6) of the PC card (5), and that the plastic frame (1) has a guide for the circuit board (5) open on its inside that retains the circuit board after its insertion into the plastic frame (1) and fixes it in position both at the top and at the bottom.

2. Casing in accordance with claim 1, **characterised in that** the guide for the circuit board (5) is in the shape of a continuous or interrupted peripheral guide slot, where the interrupted guide slot is preferably provided with lower supports (7) and upper counter-supports (8) that are offset relative to one another.

3. Casing in accordance with claim 1 or 2, **characterised by** at least one support (7) for the circuit board (5) on each side of the plastic frame (1) projecting towards the inside.

4. Casing in accordance with claim 3, **characterised in that** the supports (7) continue the lower guide faces of the guide, and in particular the guide slot, towards the inside at the same level.

5. Casing in accordance with one of claims 1 to 4, **characterised by** upper, inwardly projecting retaining projections on one side or several sides of the plastic frame.

6. Casing in accordance with claim 5, **characterised in that** the retaining projections continue the upper guide face of the guide, and in particular the guide slot, towards the inside at the same level.

7. Casing in accordance with one of claims 1 to 6, **characterised in that** the circuit board (5) and the plastic frame (1) are provided for coding purposes with an interactive projection/recess array (10, 11) in the area of the guide slot at the connecting end (4).

8. Casing in accordance with one of claims 1 to 7, **characterised in that** the circuit board (5) and the side arms (2, 3) of the plastic frame are provided with projection/recess arrays for coding purposes.

9. Casing in accordance with one of claims 1 to 8, **characterised in that** the side arms (2, 3) of the plastic frame (1) are extended so as to retain the contact strip (6) and are provided on either side with a forked holder (15, 16) that corresponds to a engaging locating projection (12, 13) of the contact strip (6) at each end so as to fix the contact strip (6) in position.

10. Casing in accordance with one of claims 1 to 9, **characterised in that** it is inserted into a metal housing which accommodates the plastic frame (1) together with the inserted circuit board (5).

## Revendications

1. Boîtier pour cartes d'ordinateur personnel (cartes PC, en particulier cartes PCMCIA; dont la plaquette imprimée est introduite dans un cadre en matière plastique et fixée dans celui-ci,
**caractérisé en ce que**
le cadre en matière plastique (1) est ouvert sur une face, de préférence sur l'extrémité de la réglette de contact (6) de la carte PC (5) et est conçu, pour l'essentiel en forme de U avec bras latéraux flexibles (2, 3) et **en ce que** le cadre en matière plastique (1) présente un guidage ouvert vers l'intérieur pour la plaquette imprimée (5), qui positionne celle-ci après son enfichage dans le cadre en matière plastique (1) et la fixe vers le haut ainsi que vers le bas.

2. Boîtier selon la revendication 1, **caractérisé en ce que** le guidage de la plaquette imprimée (5) a la forme d'une rainure de guidage périphérique continue ou discontinue, la rainure de guidage discontinue présentant de préférence des supports inférieurs (7) et des contre-supports supérieurs (8) en quinconce les uns par rapport aux autres.

3. Boîtier selon la revendication 1 ou 2, **caractérisé en ce** par au moins un guidage (7) faisant saillie vers l'intérieur pour la plaquette imprimée (5) sur chaque face du cadre en matière plastique (1).

4. Boîtier selon la revendication 5, **caractérisé en ce que** les supports (7) prolongent les faces inférieures du guidage, en particulier la rainure de guidage, au même niveau vers l'intérieur.

5. Boîtier selon l'une des revendications 1 à 4, **caractérisé par** des parties saillantes de maintien supérieures, faisant saillie vers l'intérieur, sur une ou plusieurs faces du cadre en matière plastique.

6. Boîtier selon la revendication 5, **caractérisé en ce que** les parties saillantes de maintien prolongent les faces supérieures du guidage, en particulier la rainure de guidage, au même niveau vers l'intérieur.

7. Boîtier selon l'une des revendications 1 à 6, **caractérisé en ce que** la plaquette imprimée (5) et le cadre en matière plastique (1) sont munis d'un dispositif partie saillante/évidement (10 ,11) coopérant ensemble, dans la zone de la rainure de guidage à l'extrémité d'enfichage (4), en tant que codage.

8. Boîtier selon l'une des revendications 1 à 7, **caractérisé en ce que** la plaquette imprimée (5) et les bras latéraux (2, 3) du cadre en matière plastique sont munis de dispositifs partie saillante/évidement en tant que codages.

9. Boîtier selon l'une des revendications 1 à 8, **caractérisé en ce que** les bras latéraux (2, 3) du cadre en matière plastique (1) sont prolongés pour saisir la réglette de contact (6) et sont munis sur les deux faces d'un support en fourche (15 ,16) qui correspond à une partie saillante de maintien (12, 13) venant en prise, de la réglette de contact (6)sur chaque extrémité pour la fixation de la réglette de contact (6).

10. Boîtier selon l'une des revendications 1 à 9, **caractérisé en ce qu'**il est introduit dans un boîtier métallique pour recevoir le cadre en matière plastique (14) avec plaquette imprimée introduite.
